(19) **Europäisches Patentamt / European Patent Office / Office européen des brevets**

(11) **EP 2 043 144 A2**

(12) # EUROPEAN PATENT APPLICATION

(43) Date of publication:
**01.04.2009 Bulletin 2009/14**

(51) Int Cl.:
***H01L 21/683*** (2006.01)

(21) Application number: **08253136.9**

(22) Date of filing: **25.09.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **28.09.2007 US 864288**

(71) Applicant: **INTEVAC, INC.**
**Santa Clara,**
**California 95054 (US)**

(72) Inventors:
- **Samir, Tugrul**
  **Sunnyvale, CA 94089 (US)**
- **Bluck, Terry**
  **Santa Clara, CA 95051 (US)**
- **Grimard, Dennis**
  **Ann Arbor, MI 48103 (US)**

(74) Representative: **Foster, Mark Charles et al**
**Mathisen & Macara**
**The Coach House**
**6-8 Swakeleys Road**
**Ickenham, Uxbridge UB10 8BZ (GB)**

(54) **Electrostatic chuck apparatus**

(57)    An electrostatic (110) chuck includes an angled conduit (160), or an angled laser drilled passage, through which a heat transfer gas is provided. A segment of the angled conduit (160) and/or the angled laser drilled passage extends along an axis different from an axis (147) of the electric field generated to hold a substrate (130) to the chuck, thereby minimizing plasma arcing and backside gas ionization. A first plug may be inserted into the conduit, wherein a segment of a first exterior channel thereof extends along an axis different from an axis of the electric field. A first and second plug may be inserted into a ceramic sleeve which extends through at least one of the dielectric member (117) and the electrode (115). Finally, the surface of the dielectric member may comprise embossments arranged at radial distances from the center of the dielectric member so as to improve heat transfer and gas distribution.

*Figure 6*

**Description**

**BACKGROUND**

Apparatuses and methods consistent with the present invention relate generally to an electrostatic chuck apparatus for holding a substrate.

Chucks are devices that can be used to stabilize and hold various objects, such as semiconductor substrates, while processing is performed. There are several different types of chucks, such as mechanical chucks, vacuum chucks, or electrostatic chucks.

Electrostatic chucks stabilize and hold an object by employing the attractive force, e.g., columbic force, between oppositely charged surfaces to hold the object and the chuck together. Electrostatic chucks can be used to perform a wide variety of functions such as holding silicon wafers in a process chamber for chemical and/or physical deposition apparatuses, as well as etching apparatuses.

Electrostatic chucks have many advantages over mechanical and vacuum chucks. For instance, electrostatic chucks generally apply a more uniform force than mechanical chucks or vacuum chucks. Electrostatic chucks also reduce stress-induced cracks caused by the clamps utilized by mechanical chucks and allow processing of a larger portion of the substrate. Electrostatic chucks can also be used in processes conducted at low pressures.

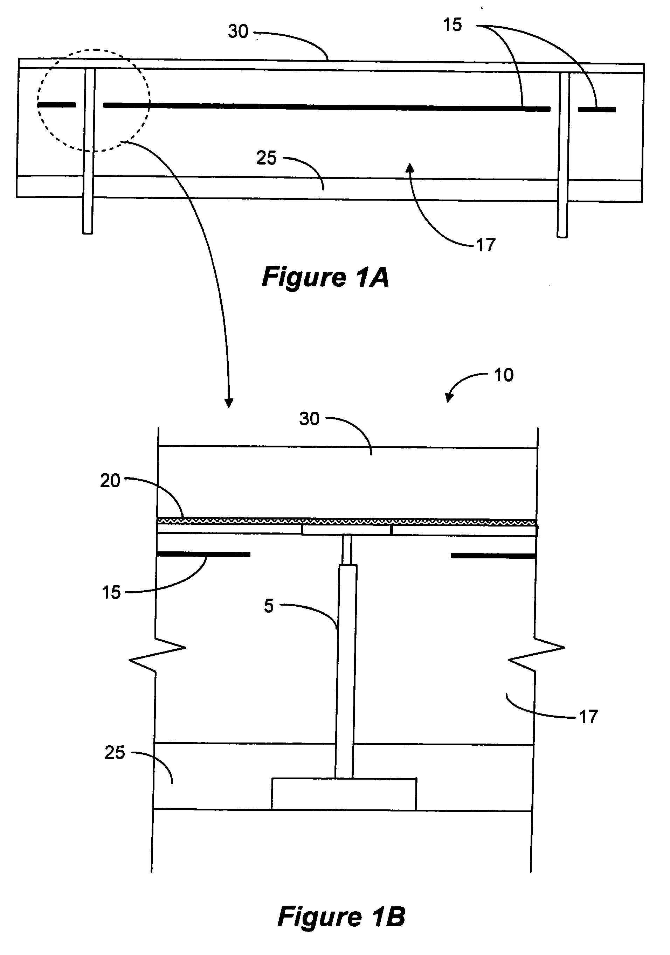

By way of example, FIGS. 1A and 1B illustrate a cross section of a typical electrostatic chuck 10 used for holding a substrate 30. The chuck 10 comprises an electrode 15 embedded in dielectric 17, a flat receiving surface 20, and a cooling base 25. When the electrode 15 is electrically charged, an opposing electrostatic charge accumulates in the substrate 30 and the resultant electrostatic force holds the substrate 30 on the receiving surface 20. Once the substrate 30 is firmly held on the receiving surface 20, plasma can be used to process the substrate 30.

Generally, during the processing of a semiconductor substrate, the substrate is repeatedly heated and cooled while undergoing various processing steps. Frequently, the processing steps, and particularly plasma processing, are performed in a vacuum chamber. However, because a vacuum does not provide heat conduction or convection, a vacuum environment provides limited heat removal from the substrate.

Typically, it is important to control the temperature of the substrate while processing is performed. However, the thermal contact between the substrate and the chuck, without more, is generally insufficient to accommodate the heat load imposed by the plasma on the substrate. Without some mechanism of improved heat transfer between the substrate being processed and adjacent surfaces, the temperature of the substrate may exceed acceptable limits. Accordingly, a heat transfer medium, which is typically a gas such as helium, is often introduced between the substrate and the chuck to enhance thermal contact and heat transfer from the substrate to the chuck. However, introducing a heat transfer medium presents several problems in conventional electrostatic chucks.

A first problem with conventional electrostatic chucks is that the need to introduce a heat transfer gas in the region between substrate and the chuck requires that some discontinuity be introduced in the chuck surface. For example, as shown in FIG. 1, some type of conduit 5 is typically formed through the surface of the electrostatic chuck 10 to a gas passage behind the surface of the electrostatic chuck 10. One drawback of introducing such conduits, however, is that plasma arcs may form from the backside of the substrate down to the metal cooling base 25. Such plasma arcs are undesirable because they can result in damage to the substrate and to the electrostatic chuck.

A second problem with conventional electrostatic chucks is that to provide a spatially uniform conductive heat transfer from the substrate to the chuck, any heat transfer medium that is introduced must be uniformly distributed along the surface of the substrate that faces the chuck.

In an attempt to address the aforementioned first problem of undesirable plasma arcing, conventional methods for reducing the likelihood of plasma arcing, include making the diameter of the conduits smaller, or increasing the thickness of the dielectric member. Additionally, plasma arcing can be reduced by moving the electrode farther away from the center of the conduit. On the other hand, if a conduit connects two metal surfaces, then such a configuration effectively increases the likelihood of plasma arcing due to the emission of free electrons from the metal surfaces. This limits the amount of RF power that may be delivered to the substrate. This limitation on power limits the etch rate and, thus, the throughput of the tool.

More particularly, one of the functions of an electrostatic chuck is to deliver both DC and RF power to the substrate and to the plasma in the chamber. This power delivery creates electric fields, which permeate the dielectrics and conduits which comprise the majority of the structure of an electrostatic chuck. These electric fields can provide energy to free electrons within the conduits which can then, in turn, impart energy to the backside heat transfer gas. This process can lead to ionization of the backside heat transfer gas which can: (1) undesirably heat the backside heat transfer gas, or (2) create a breakdown or catastrophic arc within a conduit.

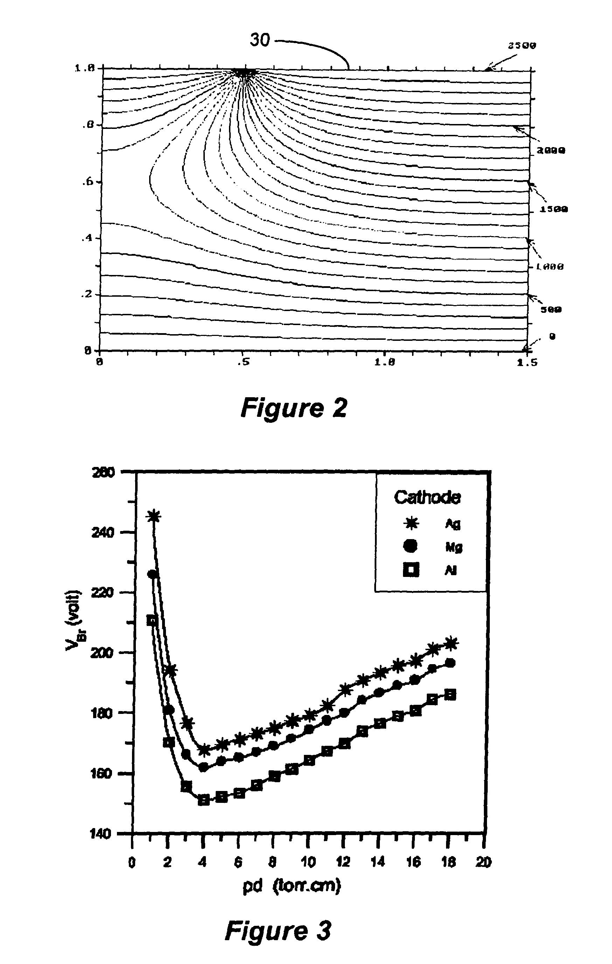

FIG. 2 illustrates a simulation representing the electric fields that exist with a conduit and a dielectric of an electrostatic chuck. In particular, FIG. 2 shows the electric fields for a RF peak-to-peak voltage of 4,000 V, a chucking voltage of 500 V, and a grounded cooling base. The resulting electric fields change somewhat over time and, therefore, FIG. 2 shows a point in the RF cycle equivalent to the substrate potential (DC and RF) of zero.

The breakdown of backside heat transfer gas can occur for many reasons. A primary reason that such breakdown can occur is that free electrons gain sufficient energy from the electric fields permeating the conduits. Such energized electrons can then ionize the backside heat transfer gas.

There are several possible options for minimizing the likelihood of electrons gaining sufficient energy to ionize the backside heat transfer gas: (1) increase the frequency at which the electrons collide with non-electron emitting surfaces, (2) decrease the electric field permeating the conduits, (3) decrease electron collisions with backside gas molecules (decrease the pressure), (4) increase the collision frequency with backside gas molecules (increase the pressure), or (5) minimize the actual voltage drop that the electrons experience in the direction of the electric field.

However, because the backside gas pressure is set by processing conditions, the options of controlling electron energy by increasing or decreasing collision frequency with the backside gas within the conduit are problematic. As will be understood by those of ordinary skill in the art, the theoretical relationship for the direct current breakdown voltage of two parallel-plate electrodes immersed in a gas, as a function of the gas pressure and electrode separation, is called the Paschen curve. As illustrated in FIG. 3, for example, a typical Paschen Curve for helium indicates a minimum voltage of approximately 150 V at $p \cdot d$ of 40 Torr.mm.

The processing conditions dictate that tool operation occur near the lowest part of the Paschen Curve. Consequently, the options of (3) decreasing electron collisions with backside gas molecules (decreasing the pressure), or (4) increasing the collision frequency with backside gas molecules (increasing the pressure) are not practical. Thus, only options (1) increasing the frequency at which the electrons collide with non-electron emitting surfaces, (2) decreasing the electric field permeating the conduits, and (5) minimizing the actual voltage drop that the electrons experience in the direction of the electric field, are practical options for minimizing the likelihood of electrons gaining sufficient energy to ionize the backside heat transfer gas.

One possibility for decreasing the electric field permeating the conduits, i.e., for achieving option (2), involves increasing the length of the conduits, since increasing the length of the conduits typically minimizes the electric field permeating the conduits due to the fixed geometric conditions of the substrate relative to the cathode. That is, for a given voltage between the substrate and the cooling base, the electric field that permeates the conduits may be reduced by simply increasing the length of the conduits (i.e., increasing the thickness of the dielectric between the substrate and the cooling base).

However, if increasing the length of the conduits does not, in fact, decrease the electric field, then simply increasing the length of the conduits may lead to an actual increase in the likelihood of ionizing the backside gas due to the increased $p \cdot d$ product for various gases, as shown below in Table 1:

**Table 1: Minimum Breakdown Potentials for Various Gases**

| Gas | Vs min (V) | $p \cdot d$ at Vs min (Torr mm) |
|---|---|---|
| Air | 327 | 5.67 |
| Ar | 137 | 9 |
| $H_2$ | 273 | 11.5 |
| He | 156 | 40 |
| $CO_2$ | 420 | 5.1 |
| $N_2$ | 251 | 6.7 |
| $N_2O$ | 418 | 5 |
| $O_2$ | 450 | 7 |
| $SO_2$ | 457 | 3.3 |
| $H_2S$ | 414 | 6 |
| (data from Naidu, M.S. and Kamaraju, V., High Voltage Engineering, 2nd ed., McGraw Hill, 1995, ISBN 0-07-462286-2). | | |

In addition, the diameter of the electrode exclusion around the conduit may also dictate the actual maximum electric field in the conduit.

Thus, there are many limitations with respect to increasing the length of the conduits (i.e., increasing the thickness of the dielectric material containing the conduit) based on RF delivery, cost of the dielectric material, and the physical limitations of manufacturing. Further, there are also limitations with respect to the electrode exclusion based on chucking requirements. That is, the diameter of the electrode exclusion cannot be so large that the chucking force is lost.

Accordingly, if it is not practical to decrease the electric field, the remaining options for minimizing the likelihood of electrons gaining sufficient energy to ionize the backside heat transfer gas are (1) increasing the collisions of the electrons with non-electron emitting surfaces and (5) minimizing the actual voltage drop that the electrons experience in the direction of the electric field. In particular, if the electric field cannot be practically decreased, then the likelihood of electrons gaining sufficient energy for ionization can be minimized by reducing the distance traveled by the electron as provided by Expression 1:

$$V = -\int_a^b \vec{E} \cdot d\vec{s} \qquad \text{(Expression 1)}$$

One way to minimize the energy gain of the electrons is to minimize the diameter of the conduits and to thereby increase the likelihood of the electrons colliding with the walls of the conduit (thus minimizing energy gain). While this technique is helpful to minimize backside gas ionization, the efficacy of this technique is nevertheless restricted by manufacturing limitations based on the aspect ratio of the conduit (aspect ratio = length / diameter). Further, laser drilling techniques may be employed, for example, to create conduits having small diameters, but such laser drilling techniques are quite expensive.

Thus, in view of these manufacturing limitations, there is a need for an electrostatic chuck for holding a substrate that minimizes the likelihood of plasma arcing and ionization of the backside heat transfer gas. In particular, there is a need for an electrostatic chuck which increases the likelihood of electrons colliding with the walls of the conduit and thereby minimizes energy gain of the electrons. There is also a need for an electrostatic chuck which minimizes the actual voltage drop that the electrons experience in the direction of the electric field.

Turning next to the second problem discussed above-that of providing a spatially uniform conductive heat transfer from the substrate to the chuck, by introducing a heat transfer medium that is uniformly distributed along the surface of the substrate that faces the chuck-this problem is particularly complicated. The thermal resistances across the interface between the substrate and the electrostatic chuck control both the absolute substrate temperature and substrate temperature uniformity. It is particularly desirable to provide temperature uniformity because features such as etch rate and selectivity are affected by substrate temperature during the plasma etching process. Moreover, non-uniform heat transfer can lead to local temperature non-uniformity on the substrate, thereby lowering yields.

As such, both the uniform distribution of the heat transfer gas, as well as the surface morphology of the electrostatic chuck, are critical. Uniform heat transfer can be accomplished by balancing the following three heat transfer mechanisms: (1) uniform backside gas pressure distribution (gas conductance, $h$), (2) uniform solid contact (contact conductance, k) and (3) radiation.

Hence, the design of the embossment pattern on the surface of the electrostatic chuck is very important to the uniform distribution of backside gas and is important to balancing the relationship between gas-phase heat transfer and solid contact heat transfer. In addition, the ability to adjust mesa contact area relative to the backside gas distribution, without a major redesign, improves the ability to test new electrostatic chuck designs rapidly.

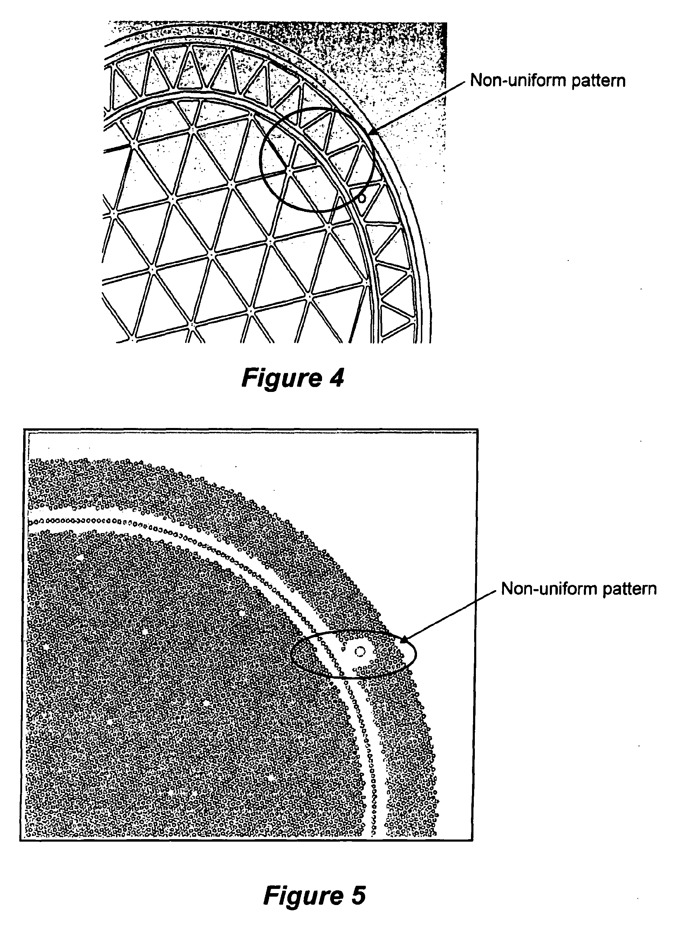

However, conventional embossment distributions can vary, as discussed below with reference to FIGS. 4 and 5. As shown in FIG. 4, for instance, conventional electrostatic chucks employing a hexagonal embossment pattern often have a non-uniform embossment distribution toward the edge of the substrate. Indeed, as shown in FIG. 4, conventional hexagonal embossment patterns form a series of aligned rows and columns and, therefore, do not provide for uniform embossment distribution at the circular boundaries (such as sealing bands and lift pin holes, for example). Further, as shown in FIG. 5, for example, conventional electrostatic chucks employing a linear embossment pattern also exhibit non-uniform embossment distribution. Thus, a drawback of conventional electrostatic chucks, such as those depicted in FIGS. 4 and 5, is that the non-uniform embossment distribution may cause non-uniform temperature distribution on the substrate.

Accordingly, there is a need for an electrostatic chuck having a surface embossment pattern which effectively balances the uniform distribution of backside gas, gas-phase heat transfer and solid contact heat transfer.

**SUMMARY**

The following summary is provided in order to provide a basic understanding of some aspects and features of the invention. This summary is not an extensive overview of the invention, and as such it is not intended to particularly identify key or critical elements of the invention, or to delineate the scope of the invention. Its sole purpose is to present some concepts of the invention in a simplified form as a prelude to the more detailed description that is presented below.

Exemplary embodiments of the present invention relate to an electrostatic chuck for holding a substrate that addresses many of the problems discussed above, and other needs which are not expressly mentioned above. Also, the present invention is not required to overcome the disadvantages described above, and an exemplary embodiment of the present invention may not overcome any of the problems described above.

According to an aspect of the present invention, there is provided an electrostatic chuck apparatus for holding a substrate, the electrostatic chuck comprising: a dielectric member defining a planar surface for supporting a substrate; an electrode embedded in the dielectric member; and at least one conduit extending through the dielectric member for backside thermal transfer gas, wherein at least one segment of the conduit extends along an axis at an oblique angle to the planar surface. At least segment of the conduit may comprise a laser drilled passage. The laser drilled passage may extend along an axis at an oblique angle to the planar surface. The laser drilled passage may extend orthogonally to the planar surface and the remainder of the conduit extends along an axis at an oblique angle to the planar surface. The laser drilled passage may extend along an axis at a first oblique angle to the planar surface and the remainder of the conduit extends along an axis at a second oblique angle to the planar surface, the second oblique angle being different from the first oblique angle. The electrostatic chuck may further comprising a porous pill at one end of the conduit. The electrostatic chuck may further comprise a plug situated inside a segment of the conduit, the plug having elongated fluid passages having an axis at an oblique angle to the planar surface. The electrostatic chuck may further comprise a first plug situated inside a segment of the conduit, the first plug having elongated fluid passages having an axis at a first oblique angle to the planar surface, and further comprising a second plug situated inside a segment of the conduit, the second plug having elongated fluid passages having an axis at a second oblique angle to the planar surface, the second angle being different from the first angle. The electrostatic chuck may further comprise a plug situated eccentrically inside a segment of the conduit, thereby enabling fluid passage about periphery of the plug.

According to other aspects of the invention, a method for fabricating an electrostatic chuck is provided, comprising: fabricating a dielectric member having an electrode embedded therein, the dielectric member having a top surface; and fabricating a fluid conduit extending through the dielectric member, wherein at least a segment of the conduit is provided in an oblique angle to the top surface. Fabricating a fluid conduit may comprise laser drilling at least a segment of the conduit. The laser drilling may be performed at an oblique angle to the top surface. The laser drilling may be performed at an orthogonal angle to the top surface. The laser drilling may be performed along an axis at a first oblique angle to the top surface and fabricating the remainder of the conduit is performed along an axis at a second oblique angle to the planar surface, the second oblique angle being different from the first oblique angle. The method may further comprise providing a porous pill at an end of the conduit. The method may further comprise fabricating a plug having elongated fluid passages having an axis at an oblique angle to the major axis of the plug; and inserting the plug into a segment of the conduit. The method may further comprise fabricating a first plug having elongated fluid passages having an axis at a first oblique angle to the major axis of the first plug; fabricating a second plug having elongated fluid passages having an axis at a second oblique angle to the major axis of the second plug, wherein the second angle is different from the first angle; and inserting the first and second plugs into a segment of the conduit. The method may further comprise fabricating a plug having a diameter smaller to a diameter of a broad segment of the conduit; and inserting the plug eccentrically into the broad segment of the conduit.

According to further aspects of the invention, an apparatus for plasma fabrication is provided, comprising: a plasma chamber; an electrostatic chuck provided inside the chamber, the electrostatic chuck comprising a dielectric member defining a planar surface for supporting a substrate; an electrode embedded in the dielectric member; and at least one conduit extending through the dielectric member for backside thermal transfer gas, wherein at least one segment of the conduit extends along an axis at an oblique angle to the planar surface. The apparatus may further comprise a plug situated inside a segment of the conduit, the plug having elongated fluid passages having an axis at an oblique angle to the planar surface.

**BRIEF DESCRIPTION OF THE DRAWINGS**

The accompanying drawings, which are incorporated in, and constitute a part of, this specification, exemplify the embodiments of the present invention and, together with the description, serve to explain and illustrate principles of the invention. The drawings are intended to illustrate major features of the exemplary embodiments in a diagrammatic manner. The drawings are not intended to depict every feature of actual embodiments nor relative dimensions of the depicted elements, and are not drawn to scale.

The aspects of the present invention will become more apparent by describing in detail exemplary embodiments thereof with reference to the accompanying drawings, in which:

FIG. 1 illustrates a straight conduit formed in an electrostatic chuck according to the related art;

FIG. 2 illustrates a simulation of electric fields permeating an electrostatic chuck;

FIG. 3 illustrates Paschen curves for different electrode materials in helium;

FIG. 4 shows a related art electrostatic chuck surface employing a hexagonal embossment pattern;

FIG. 5 shows a related art electrostatic chuck surface employing a linear embossment pattern;

FIG. 6 shows an electrostatic chuck apparatus comprising an angled conduit, consistent with an exemplary embodiment of the present invention;

FIG. 7 shows an electrostatic chuck apparatus comprising an angled laser drilled passage, consistent with an exemplary embodiment of the present invention;

FIG. 8 shows an electrostatic chuck apparatus comprising an angled laser drilled passage and an angled conduit, consistent with an exemplary embodiment of the present invention;

FIG. 9A shows an electrostatic chuck apparatus comprising a plug inserted into a conduit, consistent with an exemplary embodiment of the present invention, while FIG. 9B illustrates an embodiment similar to that of FIG 9A, except that the laser drilled hole is not oblique;

FIG. 10 shows a top surface of a plug, which is inserted into a conduit of an electrostatic chuck apparatus, consistent with an exemplary embodiment of the present invention;

FIG. 11 shows a perspective illustration of the top surface, bottom surface and the exterior surface of a plug, which is inserted into a conduit of an electrostatic chuck apparatus, consistent with an exemplary embodiment of the present invention;

FIG. 12 shows an electrostatic chuck apparatus comprising a plurality of plugs inserted into a conduit, consistent with an exemplary embodiment of the present invention;

FIG. 13 shows a top surface of a top plug among the plurality of plugs shown in FIG. 12, consistent with an exemplary embodiment of the present invention;

FIG. 14 shows a bottom surface of a bottom plug among the plurality of plugs shown in FIG. 12, consistent with an exemplary embodiment of the present invention;

FIG. 15A shows an electrostatic chuck apparatus comprising a plurality of eccentric plugs inserted into a conduit, while FIG. 15B is a perspective schematic of the top eccentric plug, consistent with an exemplary embodiment of the present invention;

FIG. 16 shows a center portion of a receiving surface of an electrostatic chuck comprising a plurality of embossments or mesas consistent with an exemplary embodiment of the present invention;

FIG. 17 shows an enlarged view of the center portion of FIG. 16, illustrating a receiving surface of an electrostatic chuck comprising a plurality of embossments or mesas consistent with an exemplary embodiment of the present invention;

FIG. 18 shows an edge portion of a receiving surface of an electrostatic chuck comprising a plurality of embossments consistent with an exemplary embodiment of the present invention;

FIG. 19 shows a receiving surface of an electrostatic chuck comprising a plurality of embossments consistent with an exemplary embodiment of the present invention, and illustrates the relative locations of the center portion shown in FIG. 16 and the edge portion shown in FIG. 18;

FIG. 20 shows a receiving surface of an electrostatic chuck comprising a plurality of embossments consistent with an exemplary embodiment of the present invention including an exemplary arrangement conduits, a lift pin hole, and a backside gas channel.

FIG. 21 illustrates a processing chamber according to an embodiment of the invention.

**DETAILED DESCRIPTION OF EXEMPLARY EMBODIMENTS**

Reference will now be made in detail to exemplary embodiments of the present invention, which are illustrated in the accompanying drawings, wherein like reference numerals refer to like elements throughout. The exemplary embodiments provided below are intended in all respects to be exemplary only, with the true scope and spirit of the invention being defined by the following claims.

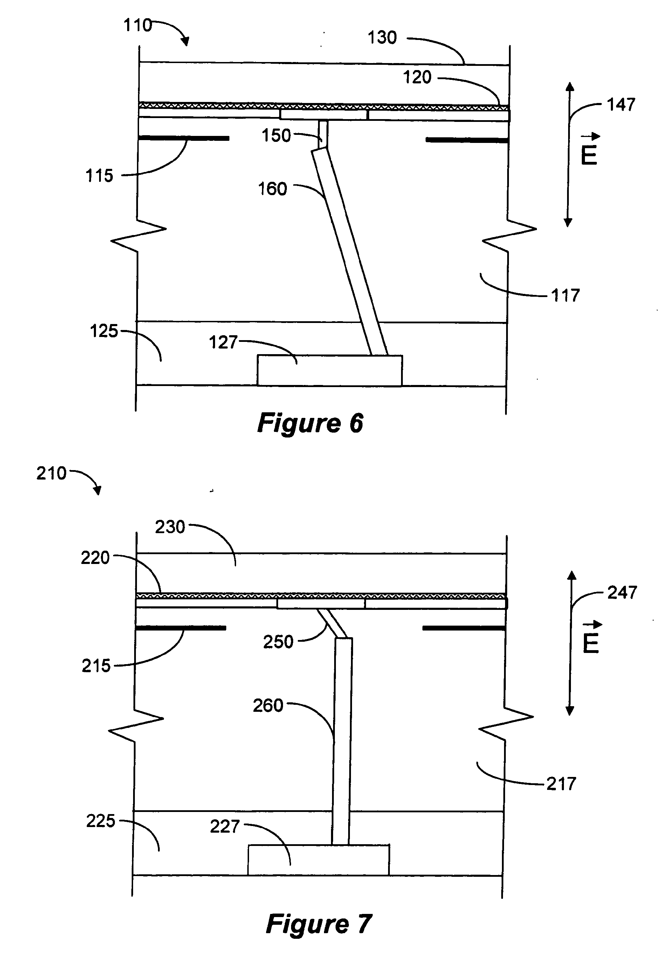

As shown in FIG. 6, an exemplary electrostatic chuck apparatus 110 consistent with the present invention is provided in a process chamber (not shown). As shown in FIG. 6, the electrostatic chuck apparatus 110 comprises a receiving surface 120 for receiving a substrate 130, such as a semiconductor wafer. The electrostatic chuck apparatus 110 can be used to securely hold the substrate 130 during various processing steps. The electrostatic chuck apparatus 110 further comprises a DC / RF electrode 115, which is disposed inside a dielectric member 117. Moreover, a cooling base 125 and an optional porous pill 127 are disposed below the dielectric member 117.

To operate the electrostatic chuck apparatus 110, a desired voltage is applied to the electrode 115 to electrostatically hold the substrate 130 to the receiving surface 120. In general, the axis 147 of the electric field resulting from the electrode 115 is roughly perpendicular to the receiving surface 120, as illustrated in FIG. 6. This is because the electrode 115 generates electrostatic forces which operate in a direction to electrostatically hold the substrate 130 to the receiving surface 120.

Additionally, the process chamber (not shown) comprises a process gas, which is energized to form a plasma by coupling RF energy to the process gas. As RF energy is applied to the plasma, the plasma is energized and charged particles are accelerated toward the substrate 130, which is held on the receiving surface 120 by electrostatic forces, to thereby process the substrate 130.

A heat transfer gas, such as Helium, is provided to enhance heat transfer rates between the substrate 130 and the electrostatic chuck apparatus 110. For example, as shown in FIG. 6, a laser drilled passage 150 is provided in the dielectric member 117. The laser drilled passage 150 connects to an angled conduit 160, which extends along an axis different from the axis of the electric field 147. In other words, the angled conduit 160 extends at an oblique non-normal or non-orthogonal angle to the receiving surface 120. A heat transfer gas, is delivered from the cooling base 125, through the angled conduit 160 and the laser drilled passage 150, to the interface between the receiving surface 120 and the substrate 130. In the context of this invention, the term oblique is used in its normal and widely accepted manner, e.g., neither perpendicular nor parallel to a given line or surface.

According to the exemplary embodiment shown in FIG. 6, an optional porous pill 127 is disposed between the dielectric member 117 and the cooling base 125. The porous material of which the porous pill 127 is composed allows backside gas to flow through to the angled conduit 160 without exposing the angled conduit 160 to the metal cooling base 125, which delivers the backside gas. If the porous pill 127 is not used, then the backside gas is delivered directly to the conduit 160.

Importantly, as shown in FIG. 6, the angled conduit 160 is angled off-axis relative to the axis 147 of the electric field. In other words, the angled conduit 160 extends along an axis that is different from the axis 147 of the electric field. Because the angled conduit 160 is angled in this way, the likelihood of free electrons from the energized plasma colliding with a non-electron emitting surface is increased. In addition, such an angled configuration of the angled conduit 160 decreases the distance traveled by such free electrons that are being accelerated by the electric field. Accordingly, angling the angled conduit 160 off-axis relative to the axis 147 of the electric field decreases the likelihood of the free electrons gaining sufficient energy to ionize the backside heat transfer gas and thereby helps to minimize plasma arcing and backside gas ionization.

According to another exemplary embodiment consistent with the present invention, as shown in FIG. 7, an electrostatic chuck 210 comprises a receiving surface 220 for receiving the substrate 230, an electrode 215 disposed in a dielectric member 217, a cooling base 225 and an optional porous pill 227. Further, as shown in FIG. 7 the angled laser drilled passage 250 provided in the dielectric member 217 is angled off-axis relative to the axis 247 of the electric field, while the conduit 260 is not angled in such a manner. That is, as shown in FIG. 7, the angled laser drilled passage 250 extends along an oblique axis that is different from the axis 247 of the electric field.

Laser drilling of the dielectric member 217 creates an angled laser drilled passage 250 having a smaller diameter than passages formed with other techniques. Such a smaller diameter of the angled laser drilled passage 250 helps to decrease the potential of ionizing backside gas. Additionally, much like the angled conduit 160 described above, since the angled laser drilled passage 250 is angled off-axis relative to the axis 247 of the electric field, the likelihood of free electrons from the energized plasma colliding with a non-electron emitting surface is increased and the distance traveled by such free electrons is decreased. Accordingly, by angling the angled laser drilled passage 250 off-axis relative to the axis 247 of the electric field, the likelihood of free electrons gaining sufficient energy to ionize the backside heat transfer gas is decreased and the likelihood of plasma arcing and backside gas ionization is reduced.

As described in the exemplary embodiments provided above, either a conduit or a laser drilled passage connected to a conduit can be angled off-axis relative to the axis of the electric field to help minimize plasma arcing and backside gas ionization. However, the present invention is not limited to these two exemplary configurations. To the contrary, according to the present invention, both components of the conduit and the laser drilled passage may be angled off-axis relative to the axis of the electric field to help minimize plasma arcing and backside gas ionization.

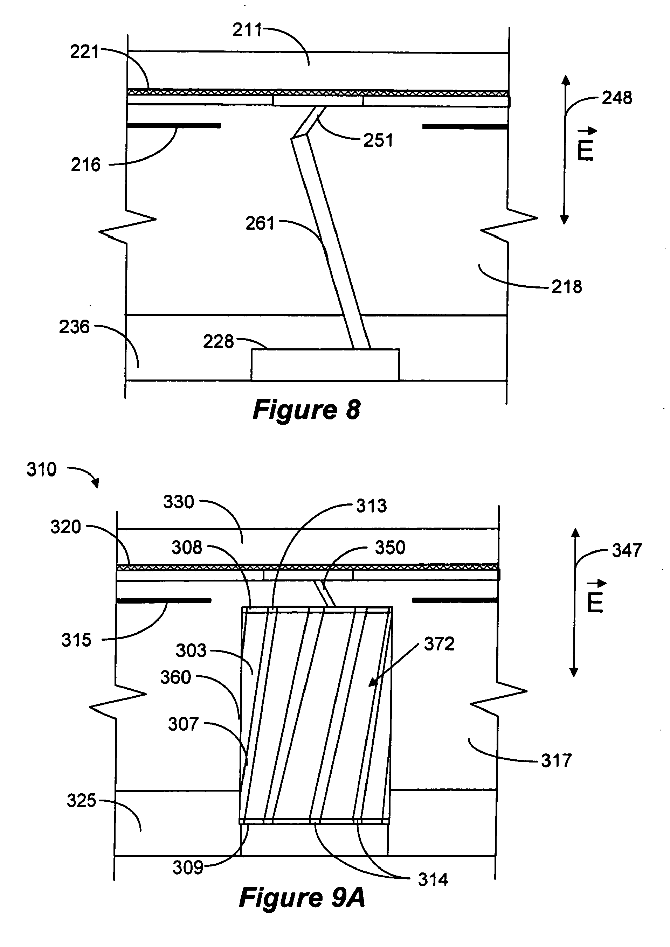

For instance, according to an exemplary embodiment of the present invention, as shown in FIG. 8, an electrostatic chuck 211 comprises a receiving surface 221 for receiving a substrate 231, an electrode 216 disposed in a dielectric member 218, a cooling base 226 and an optional porous pill 228. As shown in FIG. 8, the angled laser drilled passage 251 provided in the dielectric member 218 is angled off-axis relative to the axis 248 of the electric field. In addition, the angled conduit 261 provided in the dielectric member 218 is also angled off-axis relative to the axis 248 of the electric field. Thus, as shown in FIG. 8, both the angled laser drilled passage 251 and the angled conduit 261, extend along axes that are different from the axis 248 of the electric field.

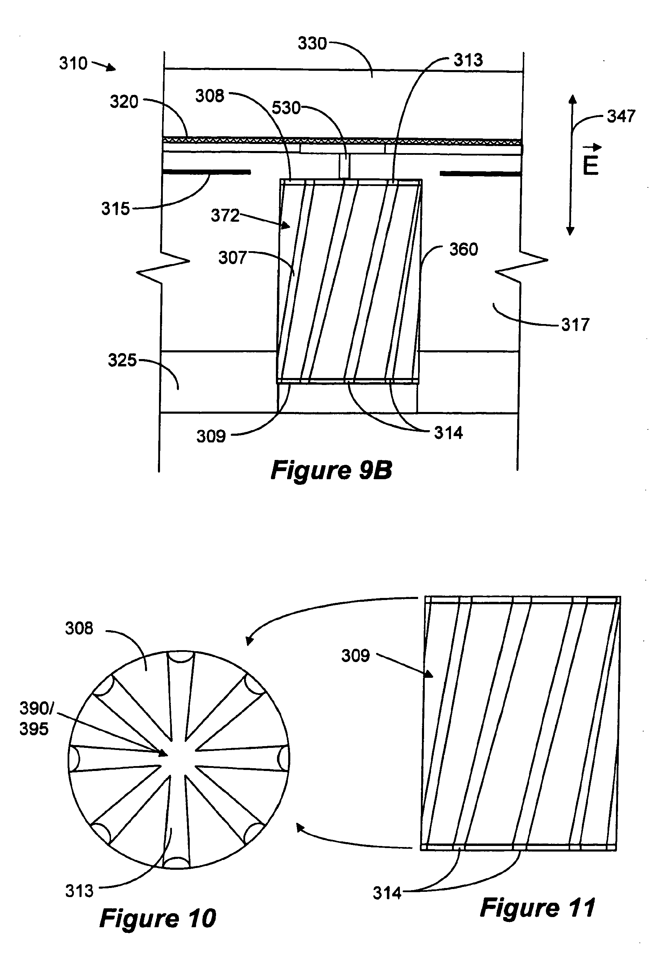

According to another exemplary embodiment of an electrostatic chuck 310 consistent with the present invention, as depicted in FIGS. 9A and 9B, an electrostatic chuck 310 comprises a receiving surface 320 for receiving the substrate 330, an electrode 315 disposed in a dielectric member 317, and a cooling base 325. Further, as shown in FIGS. 9A and 9B, a plug 303 may be inserted into a conduit 360, which is connected to a laser drilled passage 350. In the embodiment of FIG 9A the laser drilled passage 350 is angled off-axis relative to the axis 347 of the electric field, while in the embodiment of FIG 9B the laser drilled passage 350 is orthogonal to the axis 347 of the electric field.

As shown in FIGS. 9A and 9B, the plug 303 comprises a plurality of exterior channels 307 extending along the exterior surface of the plug 303. As shown in FIGS. 9A and 9B, the exterior channels 307 extend from a top surface 308 of the plug 303 to a bottom surface 309 of the plug 303. Moreover, the exterior channels 307 are arranged such that the top of each respective channel 307 does not align with the bottom of each respective channel 307. In other words, the exterior channels 307 are angled off-axis relative to the axis 347 of the electric field. It will be understood by those of ordinary skill in the art that the exterior channels 307 can be formed in the surface of the plug 303 by a variety of different methods known in the art.

As shown in FIGS. 9A and 9B, the plug 303 is substantially cylindrical in shape, however, the present invention is not limited to this particular embodiment and the plug 303 may comprise a variety of different shapes. The shape of the plug 303 may also have substantially the same shape as the conduit 360, and may correspond to the shape of the conduit 360 such that an exterior surface 372 of the plug 303 abuts the surface of the conduit 360.

FIG. 10 shows a top surface 308 of the plug 303, consistent with an exemplary embodiment of the present invention. As shown in FIG. 10, a plurality of top channels 313 are arranged on the top surface 308. More particularly, the plurality of top channels 313 extend radially from a center 390 of the top surface 308 to a perimeter of the top surface 308.

FIG. 11 shows a perspective view of the top surface 308, a bottom surface 309 and the exterior surface 372 of the plug 303. As illustrated in FIG. 11, each of the top channels 313 communicates with a respective exterior channel 307. Likewise, a plurality of bottom channels 314 are arranged on the bottom surface 309 and these bottom channels 314 extend radially from a center 395 of the bottom surface 309 to a perimeter of the bottom surface 309. As shown in FIG. 11, each of the bottom channels 314 communicates with a respective exterior channel 307.

Thus, according to the exemplary plug 303 illustrated in FIGS. 8-10, a heat transfer gas is delivered from the cooling base 325, to the bottom channels 314, and the heat transfer gas travels through the bottom channels 314 to the exterior channels 307. The heat transfer gas then travels through the exterior channels 307 to the top channels 313. The heat transfer gas travels through the top channels 313 to the center 390, and then through the laser drilled passage 350, to the interface between the receiving surface 320 and the substrate 330.

According to this exemplary embodiment, the total flow rate of the heat transfer gas can be adjusted by changing the sizes and number of the exterior channels 307, top channels 313 and bottom channels 314. Further, while the exemplary embodiment shown in FIGS. 8-10 depicts a plug 303 having a particular number of exterior channels 307 and top channels 260, the present invention is not limited thereto and a wide variety of plugs of different sizes and shapes, having different numbers of channels of different sizes may be used consistent with the present invention.

Moreover, consistent with the present invention, the diameters of the exterior channels 307 can be minimized to increase the likelihood of electrons colliding with the walls of the exterior channels 307. As a result, the energy gain of such electrons is minimized and the likelihood of backside gas ionization is reduced.

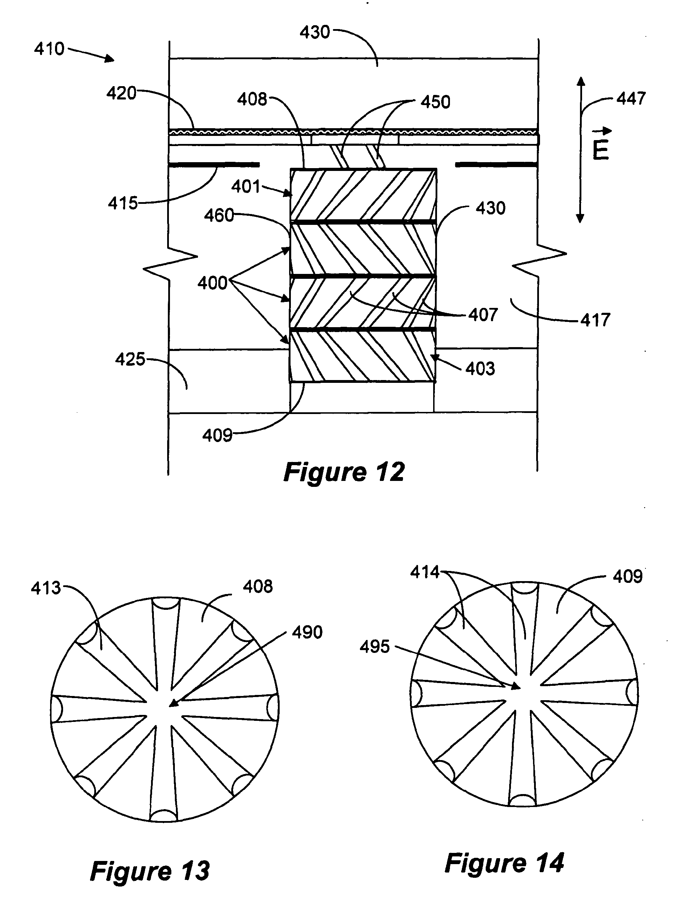

FIG. 12 illustrates yet another exemplary embodiment of the present invention. As shown in FIG. 12, an electrostatic chuck 410 comprises a receiving surface 420 for receiving the substrate 430, an electrode 415 disposed in a dielectric member 417, and a cooling base 425. According to the exemplary embodiment shown in FIG. 12, a plurality of plugs 400 are inserted into the conduit 430, and the plugs 400 are stacked on top of each other to form a stack of plugs. Each of the plugs 400 further comprises a plurality of exterior channels 407 through which a heat transfer gas is provided. As shown in FIG. 12, the bottoms of the exterior channels 407 of a top plug, are aligned with the tops of the exterior channels 407 of the plug immediately below, such that the heat transfer gas can be delivered from the exterior channels 407 of the bottommost plug in the stack to the exterior channels 407 of the uppermost plug in the stack.

FIG. 13 shows a top surface 408 of the top plug 401 from among the plurality of plugs 400 shown in FIG. 12.

As shown in FIG. 13, the top surface 408 comprises a plurality of top channels 413. More particularly, the plurality of top channels 413 extend radially from a center 490 of the top surface 408 to a perimeter of the top surface 408.

FIG. 14 shows a bottom surface 409 of the bottom plug 403 from among the plurality of plugs 400 shown in FIG. 12. As illustrated in FIG. 14, a plurality of bottom channels 414 are arranged on the bottom surface 409 and these bottom channels 414 extend radially from a center 495 of the bottom surface 409 to a perimeter of the bottom surface 409. Each of the bottom channels 414 communicates with a respective exterior channel 407 of the bottom plug 403.

Thus, according to the exemplary embodiment illustrated in FIGS. 11-13, a heat transfer gas is delivered from the cooling base 425, to the bottom channels 414, and the heat transfer gas travels through the bottom channels 414 to the exterior channels 407 of the plurality of plugs 400. Beginning with the exterior channels 407 of the bottom plug 403, the heat transfer gas then travels through the exterior channels 407 of the plurality of plugs 400 and finally through the exterior channels 407 of the top plug 401, to the top channels 413. The heat transfer gas travels through the top channels 413 to the center 490, and then through the angled laser drilled passage 450, to the interface between the receiving surface 420 and the substrate 430.

Although FIG. 12 illustrates that the plugs 400 are substantially circular in shape, a wide variety of different shaped plugs 400 may be employed consistent with the present invention. Further, as shown in FIG. 12, the laser drilled passage 450 is angled off-axis relative to the axis 437 of the electric field so as to reduce the likelihood of backside gas ionization. The exemplary embodiment shown in FIG. 12, among other advantages, provides for long path lengths and addresses the aspect ratio limitations of laser drilling.

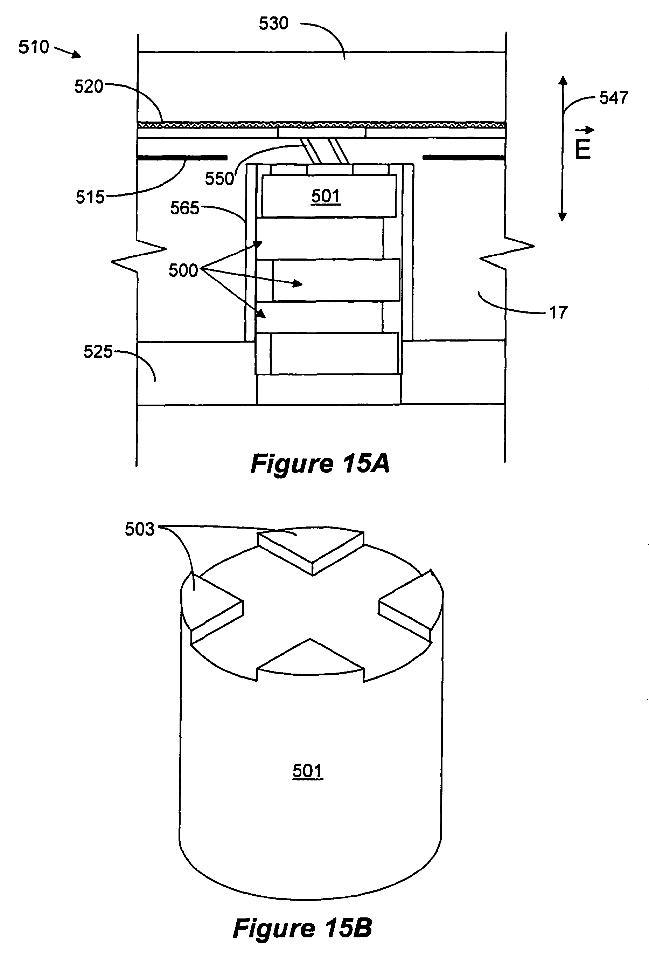

FIGS. 15A and 15B show an electrostatic chuck apparatus 510 according to another exemplary embodiment of the present invention. As shown in FIGS. 15A and 15B, an electrostatic chuck 510 comprises a receiving surface 520 for receiving the substrate 530, an electrode 515 disposed in a dielectric member 517, and a cooling base 525. Moreover, as shown in FIG. 15A, the angled laser drilled passage 550 is angled off-axis relative to the axis of the electric field.

As shown in FIG. 15A, a plurality of eccentric plugs 500 are inserted into a ceramic sleeve 565. The top eccentric plug 501 is centrally positioned to provide annular passage for backside gas flow. Further, this passage can be minimized so as to increase the likelihood of the electrons colliding with non-electron emitting surfaces. The upper part of the top eccentric plug 501 may be provided with spacers 503 to enable fluid flow to the fluid passage 550. The design of the exemplary electrostatic chuck apparatus 510 shown in FIGS. 15A and 15B also enables continuous backside gas flow from the cooling base 525 to the backside of the substrate 530 by having eccentric plugs minimizing the distance traveled by free electrons and thereby reducing the risk of backside gas breakdown.

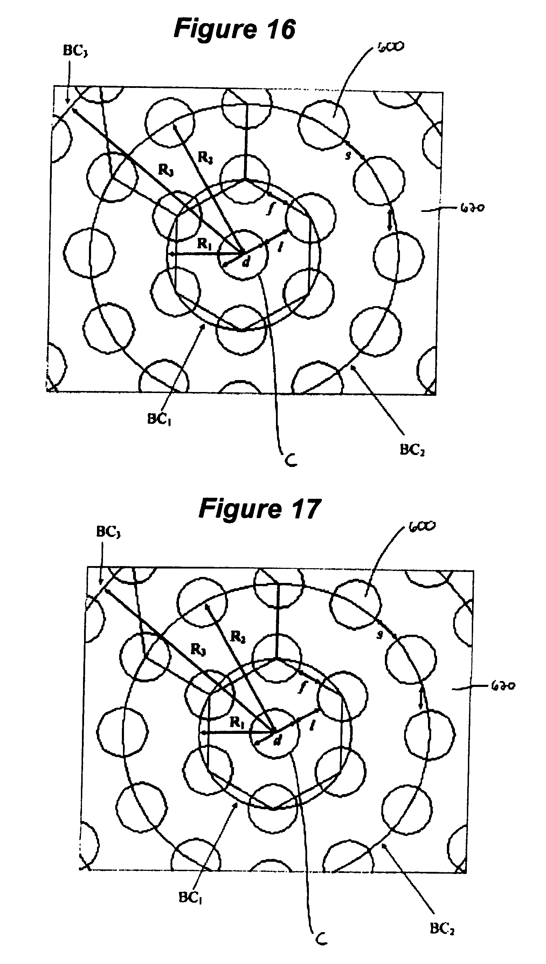

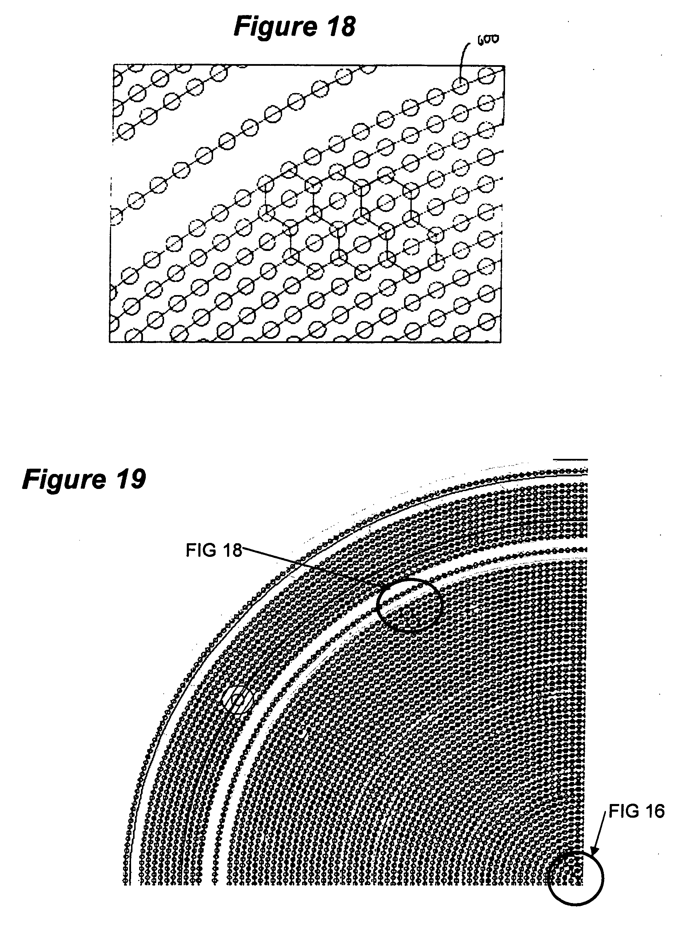

FIG. 16 illustrates a receiving surface 620 of an electrostatic chuck 610, consistent with another exemplary embodiment of the present invention. As shown in FIG. 16, a center portion of the receiving surface 620 comprises a plurality of embossments or mesas 600. FIG. 18 shows an edge portion of the receiving surface 620 comprising a plurality of embossments or mesas 600. Further, FIG. 19 shows the relative location of the center portion depicted in FIG. 16 on the receiving surface 620 and the relative location of the edge portion depicted in FIG. 18 on the receiving surface 620.

As shown in FIG. 16, the plurality of embossments or mesas 600 are arranged in a symmetrical geometric layout of concentric circles about the center C of the receiving surface 620, so as to form a plurality of bolt circles $BC_1$, $BC_2$, $BC_3$... $BC_n$. More particularly, as illustrated in FIG. 17, which shows an enlarged section of the center portion shown in FIG. 16, a first subset of the plurality of mesas 600 are arranged at a radial distance $R_1$ from the center C of the receiving surface 620, so as to form a first bolt circle $BC_1$. Similarly, a second subset of the plurality of mesas 600 are arranged at a radial distance $R_2$ from the center C of the receiving surface 620, so as to form a second bolt circle $BC_2$. Thus, both the first bolt circle $BC_1$ and the second bolt circle $BC_2$ are concentric circles formed about the center C, wherein the first bolt circle $BC_1$ has a radius $R_1$ and the second bolt circle $BC_2$ has a radius $R_2$.

According to the exemplary embodiment shown in FIGS. 16-18, each of the embossments 600 has the same diameter $d$. Since there is a relationship between total embossment area and the contact area of the electrostatic chuck 610, adjusting the embossment diameter $d$ provides for lower or higher contact area of the electrostatic chuck apparatus 610.

Further, the distance between each of the embossments comprising the first bolt circle $BC_1$ and a closest neighboring embossment from among the embossments comprising the second bolt circle $BC_2$, equals a distance $l$. As shown in FIG. 17, the embossments are arranged such that the radial distance $R_1$ of the first bolt circle $BC_1$ equals the diameter of each embossment $d$ + the distance $l$. On the other hand, the embossments are also arranged such that the radial distance $R_2$ of the second bolt circle $BC_2$ equals 2 multiplied by the radial distance $R_1$.

Although the above description has set forth one exemplary embodiment comprising two bolt circles $BC_1$ and $BC_2$, the embossments may be arranged to include any number of additional bolt circles consistent with the present invention. For example, as shown in FIG. 17, the embossments may be arranged such that the radial distance $R_3$ of a third bolt circle $BC_3$ equals 3 multiplied by the radial distance $R_1$. That is, according to various exemplary embodiments of the present invention, the embossments may be arranged on the receiving surface 620 such that the radial distance $R_n$ each bolt circle $BC_n$ equals n multiplied by the radial distance $R_1$.

According to an exemplary embodiment of the present invention, the embossments may be arranged on the receiving surface 620 such that a total number of embossments m on the receiving surface 620 equals $n \times 6$. Moreover, as shown in FIG. 17, the embossments within each bolt circle may be arranged equidistant from each other. For example, each of the embossments comprising the first bolt circle $BC_1$ may be arranged such that the distance between each of the embossments in the first bolt circle $BC_1$ and a closest neighboring embossment, from among the embossments in the first bolt circle $BC_1$, is a distance $f$. Further, each of the embossments comprising the second bolt circle $BC_2$ may be arranged such that the distance between each of the embossments in the second bolt circle $BC_2$ and a closest neighboring embossment, from among the embossments in the second bolt circle $BC_2$, is a distance s. According to an exemplary embodiment of the present invention, the embossments can also be arranged such that the distance $f$ equals the distance *s*.

The various arrangements of embossments described above provide for a uniform geometric layout as particularly illustrated in FIG. 19. That is, as shown in FIG. 19, the embossments 600 are uniformly distributed. Accordingly, when maximum contact is desirable, the present invention provides for "close packing" or the densest possible arrangement of mesas. On the other hand, when lesser contact is desirable, the present invention provides that the locations of the mesa centers will not change.

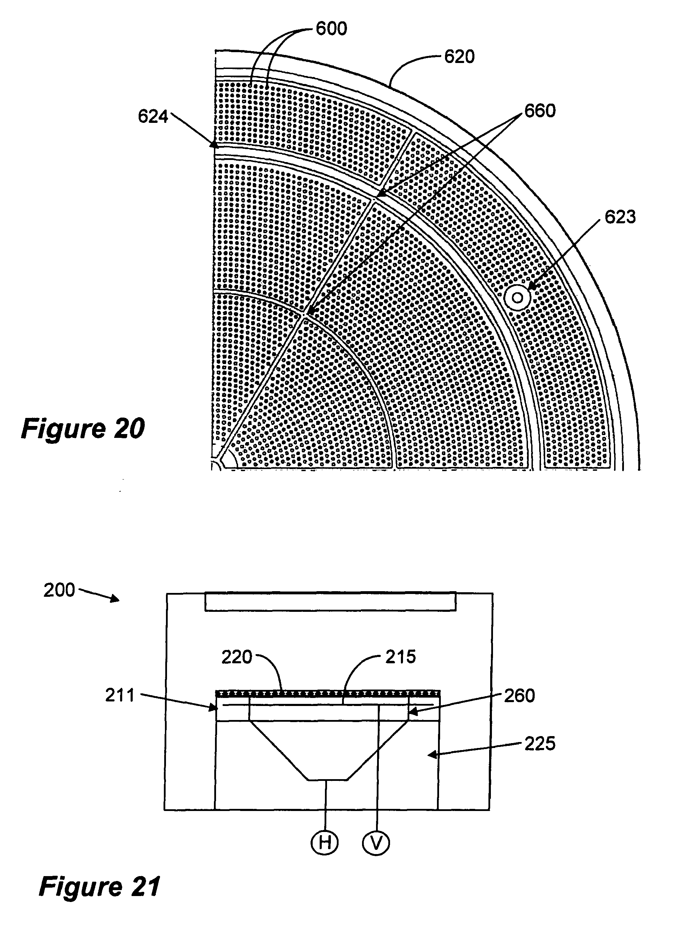

In addition to the advantages of the symmetrical arrangement of embossments, as described above, the above concepts may also be applied to the arrangement of conduits with respect to the receiving surface 620. That is, as shown in FIG. 20, the conduits 660 on the receiving surface 620 may be located such that the sources of heat transfer gas on the receiving surface 620 provide for a uniform pattern within the symmetry of the embossments 600. For instance, the conduits 660 may be arranged such that no point on the receiving surface 620 is any farther away from a heat transfer gas source than any other point.

As shown in FIG. 20, the receiving surface 620 further comprises lift pin holes 623 for receiving lift pins (not shown) that are raised and lowered by a pneumatic lift mechanism, for instance, so as to raise or lower the substrate 630 from / to the receiving surface 620. As shown in FIG. 20, the receiving surface 620 also comprises a seal band 624.

FIG. 21 illustrates a processing chamber 200 according to an embodiment of the invention. The processing chamber may be utilized to process semiconductor wafers for the fabrication of microchips. In this context, the chamber 200 may be, for example, a plasma chamber for etching of semiconductor wafers. The chamber 200 includes a base 225 upon which the electrostatic chuck 211 is positioned. The electrostatic chuck includes an electrode 215 which is biased by power supplier V. Backside cooling gas from source H is provided to cooling fluid conduits 260. The fluid conduits may be implemented according to any of the inventive conduits described above. The top surface 220 of the chuck 211 may includes mesas arranged according to any of the embodiments described above. It should be noted, however, that the use of the inventive fluid conduits and inventive mesa arrangement is independent of each other. That is, chuck 211 may include fluid conduits according to the subject invention while having a conventional embossments. On the other hand, the chuck 211 may include conventional fluid conduit, while utilizing embossments according to the subject invention. Of course, the chuck 211 may include both the inventive fluid conduits and embossments.

Exemplary embodiments of the present invention employing an embossment pattern, as explained above, provide a mechanism for morphing a plurality of embossments to fit into a circular geometry. Such a configuration reduces the non-uniformity around any circular feature on the surface of an electrostatic chuck. In addition to the mesa topology, the groove length and spacing may be aligned for optimal backside gas uniformity to improve heat transfer. The grooves may also follow a symmetry that provides for overall symmetry of the grooves, the conduits and the mesas.

Exemplary embodiments employing an embossment pattern, as discussed above, also reduce the number of backside gas holes, thereby minimizing cost since it enables uniform gas distribution for substrate cooling by uniformly and minimally locating backside conduits across the electrostatic chuck surface.

The present invention has been described in relation to particular examples, which are intended in all respects to be illustrative rather than restrictive. Various other implementations of the invention will be apparent to those skilled in the art from consideration of the specification and practice of the invention disclosed herein. It is intended that the specification and examples be considered as exemplary only, with a true scope and spirit of the invention being indicated by the following claims.

## Claims

1.   An electrostatic chuck for holding a substrate, the electrostatic chuck comprising:

a dielectric member defining a planar surface for supporting a substrate;
an electrode embedded in the dielectric member; and
at least one conduit extending through the dielectric member for backside thermal transfer gas, wherein at least one segment of the conduit extends along an axis at an oblique angle to the planar surface.

2. An apparatus for plasma fabrication, comprising:

a plasma chamber;
an electrostatic chuck provided inside the chamber, the electrostatic chuck comprising:

a dielectric member defining a planar surface for supporting a substrate;
an electrode embedded in the dielectric member; and
at least one conduit extending through the dielectric member for backside thermal transfer gas, wherein at least one segment of the conduit extends along an axis at an oblique angle to the planar surface.

3. The electrostatic chuck according to claim an apparatus according to claim 2,
wherein at least segment of the conduit comprises a laser drilled passage.

4. The electrostatic chuck or apparatus according to claim 3, wherein the laser drilled passage extends along an axis at an oblique angle to the planar surface.

5. The electrostatic chuck or apparatus according to claim 3, wherein the laser drilled passage extends orthogonally to the planar surface and the remainder of the conduit extends along an axis at an oblique angle to the planar surface.

6. The electrostatic chuck or apparatus according to claim 3, wherein the laser drilled passage extends along an axis at a first oblique angle to the planar surface and the remainder of the conduit extends along an axis at a second oblique angle to the planar surface, the second oblique angle being different from the first oblique angle.

7. The electrostatic chuck or apparatus according to any one of claims 1 to 6, further comprising a porous pill at one end of the conduit.

8. The electrostatic chuck or apparatus according to any one of claims 1 to 7, further comprising a plug situated inside a segment of the conduit, the plug having elongated fluid passages having an axis at an oblique angle to the planar surface.

9. The electrostatic chuck or apparatus according to any one of claims 1 to 7, further comprising a first plug situated inside a segment of the conduit, the first plug having elongated fluid passages having an axis at a first oblique angle to the planar surface, and further comprising a second plug situated inside a segment of the conduit, the second plug having elongated fluid passages having an axis at a second oblique angle to the planar surface, the second angle being different from the first angle.

10. The electrostatic chuck or apparatus according to any one of claims 1 to 7, further comprising a plug situated eccentrically inside a segment of the conduit, thereby enabling fluid passage about periphery of the plug.

11. A method for fabricating an electrostatic chuck, comprising:

fabricating a dielectric member having an electrode embedded therein, the dielectric member having a top surface;
fabricating a fluid conduit extending through the dielectric member, wherein at least a segment of the conduit is provided in an oblique angle to the top surface.

12. The method according to claim 11, wherein fabricating a fluid conduit comprises laser drilling at least a segment of the conduit.

13. The method according to claim 12, wherein the laser drilling is performed at an oblique angle to the top surface.

14. The method according to claim 12, wherein the laser drilling is performed at an orthogonal angle to the top surface.

15. The method according to claim 12, wherein the laser drilling is performed along an axis at a first oblique angle to the top surface and fabricating the remainder of the conduit is performed along an axis at a second oblique angle to the planar surface, the second oblique angle being different from the first oblique angle.

16. The method according to any one of claims 11 to 15, further comprising:

providing a porous pill at an end of the conduit.

17. The method according to any one of claims 11 to 15, further comprising:

fabricating a plug having elongated fluid passages having an axis at an oblique angle to the major axis of the plug; and
inserting the plug into a segment of the conduit.

18. The method according to any one of claims 11 to 15, further comprising:

fabricating a first plug having elongated fluid passages having an axis at a first oblique angle to the major axis of the first plug;
fabricating a second plug having elongated fluid passages having an axis at a second oblique angle to the major axis of the second plug, wherein the second angle is different from the first angle; and
inserting the first and second plugs into a segment of the conduit.

19. The method according to any one of claims 11 to 15, further comprising:

fabricating a plug having a diameter smaller to a diameter of a broad segment of the conduit; and
inserting the plug eccentrically into the broad segment of the conduit.

30       15

25

17

**Figure 1A**

10

30

20

15

5

25

17

**Figure 1B**

30

**Figure 2**

**Figure 3**

**Figure 4**

**Figure 5**

**Figure 6**

**Figure 7**

**Figure 8**

**Figure 9A**

**Figure 9B**

**Figure 10**

**Figure 11**

*Figure 12*

*Figure 13*

*Figure 14*

**Figure 15A**

**Figure 15B**

## Figure 16

## Figure 17

## Figure 18

## Figure 19

FIG 18

FIG 16

Figure 20

Figure 21

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **NAIDU, M.S. ; KAMARAJU, V.** High Voltage Engineering. McGraw Hill, 1995